# EUROPÄISCHE PATENTSCHRIFT

(11) **EP 1 399 945 B1**
(45) Veröffentlichungstag und Bekanntmachung des Hinweises auf die Patenterteilung: **13.04.2005**
(21) Anmeldenummer: 02727150.1
(22) Anmeldetag: 30.05.2002
(51) Int. Cl.: H01J 37/34

(54) **MAGNETRONZERSTÄUBUNGSQUELLE**
MAGNETRON ATOMISATION SOURCE
SOURCE DE PULVERISATION DE MAGNETRON

(30) Priorität: 12.06.2001 CH 105201
(43) Veröffentlichungstag der Anmeldung: 24.03.2004
(73) Patentinhaber: Unaxis Balzers Aktiengesellschaft, 9496 Balzers (LI)
(72) Erfinder: HEINZ, Bernd, CH-9470 Buchs (CH); DUBS, Martin, CH-9477 Trübbach (CH); EISENHAMMER, Thomas, CH-9478 Azmoos (CH); GRÜNENFELDER, Pius, CH-7323 Wangs (CH); HAAG, Walter, CH-9472 Grabs (CH); KADLEC, Stanislav, CH-9470 Buchs (CH); KRASSNITZER, Siegfied, A-6800 Feldkirch (AT)
(86) Internationale Anmeldenummer: PCT/CH2002/000285
(87) Internationale Veröffentlichungsnummer: WO 2002/101785

(56) Entgegenhaltungen:
- EP-A- 0 393 957
- US-A- 5 262 028
- US-A- 5 284 564
- US-A- 5 688 381

## Beschreibung

Die Erfindung betrifft eine Magnetronzerstäubungsquelle gemäss dem Oberbegriff des Patentanspruches 1 und deren Verwendung gemäss Patentanspruch 17.

Magnetronzerstäubungsquellen dieser Art sind seit vielen Jahren bekannt und dienen der Beschichtung von Substraten im Vakuum. Solche Magnetronzerstäubungsquellen zeichnen sich dadurch aus, dass mit Hilfe eines Magnetfeldes ein dichtes Plasma vor der zerstäubenden Targetoberfläche erzeugt wird, welches erlaubt das Target durch Ionenbeschuss mit hoher Rate zu zerstäuben und eine Schicht auf dem Substrat mit hoher Aufwachsrate zu erzielen. Bei solchen Magnetronzerstäubungsquellen dient das Magnetfeld als Elektronenfalle, welche die Entladungsbedingungen der Gasentladung und Plasmaeinschluss ganz wesentlich bestimmt. Das Magnetfeld einer solchen Magnetronelektronenfalle ist derart ausgebildet, dass im Bereich der Rückseite eines zu zerstäubenden Targets geschlossene Magnetpolschleifen angeordnet sind , welche sich nicht überschneiden und im speziellen Fall eine kreisringförmige Anordnung bilden und auch konzentrisch angeordnet sein können, wobei diese Magnetpolschleifen gegenpolig, beabstandet angeordnet sind derart, dass sich Feldlinien zwischen den Polen schliessen und hierbei mindestens teilweise das Target durchdringen, wo sie im Bereich der Zerstäubungsfläche die Elektronenfallenwirkung bestimmen. Durch die ineinander beziehungsweise konzentrisch angeordneten Polschleifen entsteht im Targetoberflächenbereich ein tunnelartig ausgebildetes Magnetfeld, welches eine geschlossene Schleife bildet in welchen die Elektronen gefangen und geführt werden. Durch diese charakteristische Ausgestaltung der Magnetronelektronenfalle entsteht ebenfalls eine ringförmige Plasmaentladung mit inhomogener Plasmadichteverteilung, welche dazu führt, dass das Target durch den ungleichmässigen Ionenbeschuss ebenfalls ungleichmässig erodiert wird. Typischerweise entsteht bei solch einer Magnetronentladung ein ringförmiger Erosiönsgraben während dem Betrieb, wodurch auch Probleme bei der Schichtdickenverteilung am Substrat entstehen und zu lösen sind. Ein weiterer Nachteil ist, dass durch die entstehenden grabenförmigen Erosionsmuster des Targets die Ausnutzung des Targetmaterials eingeschränkt wird.

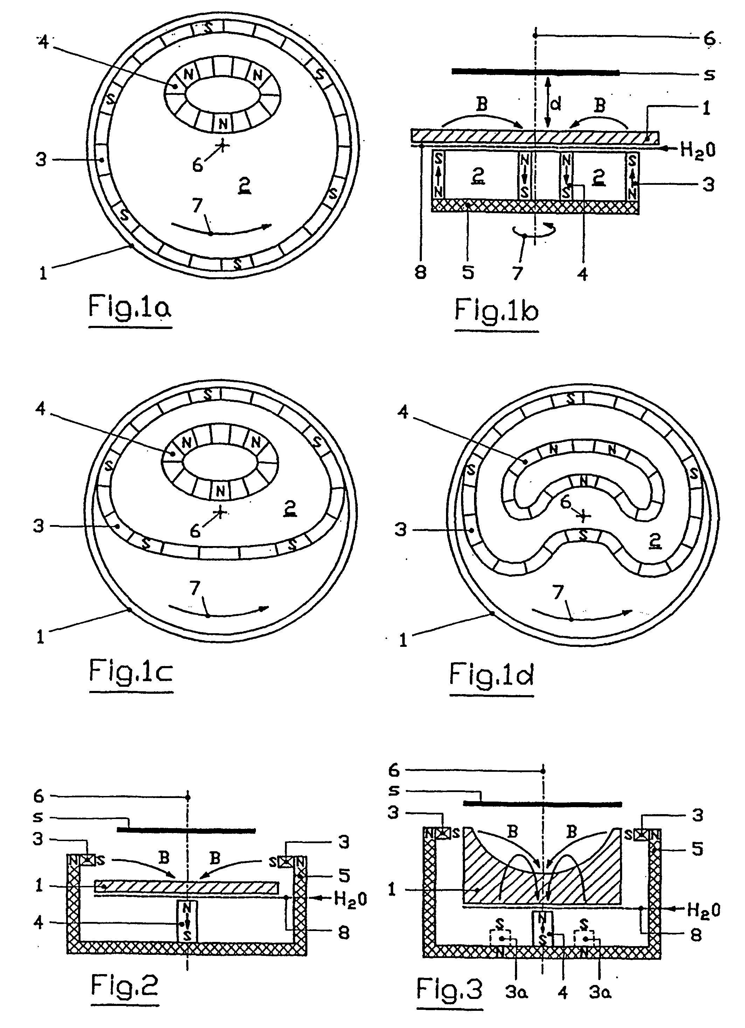

Diese Probleme wurden bereits gemäss der DE OS 27 07 144 entsprechend der US 5,284,564 erkannt. Es wird als Lösung vorgeschlagen, zwischen der schleifenförmigen Plasmaentladung und dem Target eine Relativbewegung zu erzeugen, so dass das Plasma die Targetoberfläche überstreicht. Dadurch soll das Erosionsprofil am Target verbreitert beziehungsweise abgeflacht werden und gleichzeitig die Schichtverteilung am davor angeordneten Substrat verbessert werden. Bei rechteckigen Magnetronzerstäubungsanordnungen wird, beispielsweise gemäss der Figur 1, das Magnetsystem welches die Elektronenfalle erzeugt, hinter dem flachen Target hin und her bewegt. Bei runden Zerstäubungsquellen werden beispielsweise die Magnetsysteme gemäss den Figuren 22 bis 25 hinter dem Target um die Targetachse rotiert. Hierdurch wird erreicht, dass die Plasmaschleife die runde Targetplatte rotierend überstreicht. In den Figuren 22 und 25 ist ausserdem dargestellt, dass die Elektronenfallenschleife verschieden geformt werden kann und dadurch das resultierende Erosionsprofil beeinflusst werden kann.

Bei Anordnungen, in welchen die Substrate gegenüber dem Magnetrontarget stationär angeordnet sind oder in sich selbst in einer Ebene vor dem Target rotieren, beziehungsweise bei welchen bereits in der Substratebene über einen möglichst grossen Bereich hohe Homogenitätsanforderungen der Beschichtung erfüllt werden müssen, stellen sich besondere Probleme weil die Verteilungs- und die Materialausnutzungsproblematik hauptsächlich bereits quellenseitig gelöst werden müssen und nicht durch vorbei Bewegung des Substrates gelöst werden können. Beschichtungsanlagen dieser Art, wo scheibenförmige Substrate im Takt eingeschleust werden und vor einer Magnetronzerstäubungsquelle positioniert und dort beschichtet werden, haben in den letzen Jahren stark an Bedeutung gewonnen. Auf diese Art und Weise werden heute bevorzugt Halbleiterwafer bearbeitet bzw. beschichtet zur Herstellung von elektronischen Bauteilen, sowie Speicherscheiben zur Herstellung von magnetischen Speicherplatten und zur Herstellung von optischen und optomagnetischen Speicherplatten.

Für die Beschichtung von stationär angeordneten Scheibenförmigen Substraten wurden bereits vor 1980 erste kreisringförmige Zerstäubungsquellen eingesetzt. Wie bereits erwähnt entsteht durch die ringförmige Plasmaschleife ein stark ausgeprägter ringförmiger Erosionsgraben im Target, was zu Problemen mit der Schichtverteilung am Substrat führt bei hohen Genauigkeitsauforderungen. Bei solchen Quellenanordnungen musste deshalb der Abstand zwischen dem Target und dem zu beschichtenden Substrat relativ gross gewählt werden, typischerweise im Bereich von 60 bis 100 mm. Um gute Verteilungswerte zu erhalten, musste ausserdem der Targetdurchmesser um einiges grösser gewählt werden als der Substratdurchmesser. Sowohl der relativ grosse Targetsubstratabstand wie auch der relativ grosse Überhang des Targetdurchmessers führte praktisch dazu, dass die Ausnutzung des abgestäubten Materials insgesamt schlecht war. Wegen der daraus folgenden geringen Wirtschaftlichkeit und den laufend steigenden Verteilungsanforderungen an die Beschichtung wurden runde Magnetronquellenanordnungen mit rotierenden Magnetsystemen entwickelt, welche diesbezüglich weitere Verbesserungen ermöglichten. Um die Materialausnutzuung und die Beschichtungsrate zu erhöhen wurde erkannt, dass der Targetsubstratabstand und der Targetdurchmesser verringert werden muss. Dies ist nur dann möglich wenn einerseits der Plasmaeinschluss auf die Weise erfolgt, dass die Plasmaausdehnung das zu beschichtende Substrat nicht stört und andererseits der Targetabtrag über die Fläche homogenisiert wird und insbesondere auch im Bereich der Targetmitte her abgestäubt wird.

Ein erster Verbesserungsschritt konnte erreicht werden gemäss einer Anordnung wie sie in Figur 1a dargestellt ist. Das Magnetsystem 2 besteht aus einem äusseren kreisringförmigen Magnetpol 3 und einem inneren exzentrisch versetzten Gegenpol 4. Das Magnetsystem 2 ist um eine zentrale Rotationsachse 6 drehbar gelagert und wird in Rotationsrichtung 7 durch einen Antrieb, wie mit einem Elektromotor, gegenüber dem feststehenden Target rotiert. Durch die exzentrische Anordnung des Innenpols 4 entsteht bei Anlegen einer Entladungsspannung an das Target 1 eine exzentrisch rotierende Pläsmaschleife welche einen grösseren Teil des Targets überstreicht. In Figur 1b ist diese Anordnung im Querschnitt dargestellt, wobei das Magnetsystem 2 um die Quellenzentrumsachse 6 in Drehrichtung 7 rotierbar gelagert ist, das Substrat s ist über einen Abstand d (typischerweise im Bereich von 40 bis 60 mm) von der runden Targetplatte 1 beabstandet angeordnet, wobei das Target 1 über eine Kühlvorrichtung 8, beispielsweise wassergekühlt ist. Das Magnetsystem 2 ist mit Permanentmagneten 3,4 aufgebaut wobei diese derart angeordnet sind, dass der äussere Pol 3 und der Innenpol 4 derart beabstandet und gegenpolig angeordnet sind, dass die erzeugten Feldlinien B durch das Target 1 hindurch treten und über der Targetoberfläche die geschlossene tunnelförmige Magnetfeldschleife bilden, welche eine Elektronenfalle ausbilden. Der Rückschluss der Permanentmagnete erfolgt über eine Jochplatte 5 aus hochpermeablem Material, wie Eisen, welche auf derjenigen Seite der Permanentmagnetpole angeordnet ist, welche vom Target 1 weiter entfernt ist. Um eine Exzentrizität der Plasmaschleife zu erzeugen wurde der Innenpol 4 gegenüber der Rotationsachse 6 versetzt. Durch Wahl dieser Exzentrizität kann in einem gewissen Bereich die Erosions- und Verteilungscharakteristik optimiert werden.

Eine weitere wesentliche Verbesserung der Magnetsystemanordnung ist möglich durch vollständig exzentrische Ausbildung des magnetischen Kreises gemäss den Figuren 1c und 1d. Die in Figur 1c dargestellte im wesentliche gleichmässige Breite des magnetischen Tunnels entlang der ganzen geschlossenen Schleife ermöglicht eine konstantere und effizientere Elektronenfallenwirkung und vor allem eine klarere Definition der Exzentrizität der Plasmaschleife, was zur besseren Ergebnissen führt. In.Figur 1d ist eine weitere Ausführungsform gezeigt, bei welcher die Plasmaschleife in sich nochmals gefaltet wird beispielsweise in Form einer Art Kardioide. Je nach Grösse der Target- und Substratdimensionen ergeben sich eine grosse Anzahl von möglichen Schleifenformen, wie beispielsweise auch gefaltete Plasmaschleifen, welche der Optimierung der Abstäub- und Verteilungsverhältnisse am Substrat dienen. Der Vorteil dieser rotierenden Anordnungen liegt nicht zuletzt darin, dass alleine schon über die geometrische Ausbildung die Ergebnisse gut voraus berechnet werden können. Weitere Simulationsrechnungen sind möglich zur Optimierung des Designs.

Magnetronzerstäubungsquellen mit rundem planaren Target und mit rotierenden Magnetsystemen werden seit vielen Jahren von der Firma Balzers Aktiengesellschaft in Liechtenstein vertrieben beispielsweise unter der Typenbezeichnung AR 125 wie diese auch beschrieben ist in der Betriebsanweisung (BB 800 463 BD) zur Quelle in der ersten Ausgabe Mai 1985.

Eine weitere Möglichkeit das Erosionsprofil zu beeinflussen besteht darin, den äusseren Magnetpol in Richtung der Targetzerstäubungsfläche, parallel zur Quellenachse 6, zu verschieben, wie dies in Figur 2 dargestellt ist. Dadurch wird der Feldlinienverlauf B verändert insbesondere abgeflacht, so dass das Erosionsprofil verbreitert werden kann. Bei solchen Anordnungen mit hochgezogenen Magnetpolen ist es auch möglich den Innenpol 4 im Zentrum hochzuziehen, wenn nötig ebenfalls bis über die Zerstäubungsfläche des Targets 1 wenn das Target im Zentrum eine dafür vorgesehene Öffnung aufweist und die vorgesehene Zerstäubungscharakteristik dies erlaubt. Bei stationärer Beschichtungsanordnung des Substrates s hat diese Quellenausbildung den Nachteil, dass einerseits relativ grosse Target-Substratabstände notwendig sind, die Ausnutzung des zerstäubten Materials welches auf dem Substrat s ankommt relativ gering ist, weil die im Aussenbereich liegenden Zonen, die nicht genutzt werden können anteilmässig gross sind und die Targetausnutzung geringer ist als bei rotierenden Systemen.

Eine weitere und wesentlich verbesserte Ausbildung einer Magnetronzerstäubungsquellenanordnung zur Beschichtung von scheibenförmigen Substraten s ist in Figur 3 dargestellt und beschrieben in der EP 0 676 791 B1 entsprechend der US 5,688,381. Diese Quellenanordnung besitzt ebenfalls hochgezogene Aussenpole 3 wobei der Polbereich vorzugsweise selbst als Permanentmagnet ausgebildet ist und der magnetische Rückschluss gegenüber dem zentral liegenden Innenpol 4 über ein Eisenjoch 5 erfolgt. Bei dieser Quelle ist der Targetkörper 1 nach innen gewölbt, also konkav, ausgebildet und die Elektronenfalle derart festgelegt, dass der durch die Innenwölbung des Targets 1 erzeugte Hohlraum in wesentlichen den Plasmaentladungsraum bildet. Hierdurch ist es möglich mit dem Substrat s sehr nahe an das Target 1 heranzugehen, beispielsweise 35 mm bei einem Substratdurchmesser von 120 mm wobei der Targetdurchmesser nicht wesentlich grösser ist als der Substratdurchmesser. Hierdurch wird der Entladungsraum zwischen dem konkav ausgebildeten Target 1 und dem Substrat im wesentlichen durch das Substrat und die Zerstäubungsfläche abgeschlossen. Dies hat zur Folge, dass das zerstäubte Material zu einem sehr grossen Teil auf das Substrat übertragen wird und die Randverluste gering sind. Mit dieser Quellenanordnung sind deshalb hohe Beschichtungsraten bei sehr guter Wirtschaftlichkeit möglich. Gewisse Beschränkungen treten allerdings dadurch auf, dass die Steuerung des Erosionsprofils und der Verteilung und das Erzielen von reproduzierbaren Verhältnissen, insbesondere über die Targetlebensdauer, diesbezüglich schwierig ist. Es wurde deshalb versucht mit zusätzlichen Aussenpolanordnungen 3a welche zwischen dem Innenpol 4 und dem Aussenpol 3 liegen die Plasmaentladung derart zu beeinflussen, dass bei vertieften Erosionsprofil eine Verschiebung des Plasmaringes erfolgt, um eine bestimmte Kompensatiönswirkung zu erzielen. Bei sehr hohen geforderten Verteilungsanforderungen und Materialausnutzungsgraden hat aber diese Methode gewisse Beschränkungen.

Die vorliegende Erfindung hat es sich zur Aufgabe gemacht die Nachteile des Standes der Technik zu beseitigen. Insbesondere stellt sich die vorliegende Erfindung die Aufgabe eine Magnetronzerstäubungsquelle mit hochgezogener Aussenpolmagnetanordnung zu realisieren, welche die Vorteile von hohen Zerstäubungsraten bei hohen Materialnutzungsgraden vereint mit sehr guten erzielbaren Verteilungswerten am Substrat während der ganzen Targetlebensdauer, bei stabilen und reproduzierbaren Verhältnissen. Ausserdem soll die Magnetronzerstäubungsquelle eine hohe Gesamtwirtschaftlichkeit aufweisen.

Diese Aufgabe wird ausgehend von einer Magnetronzerstäubungsquelle eingangs genannter Art durch deren Ausbildung nach dem kennzeichnenden Teil von Anspruch 1 erreicht.

Dadurch, dass erfindungsgemäss der ringförmige Aussenpol nicht in gleicher Ebene mit dem Innenpol liegt und im Randbereich des runden Targetkörpers gegenüber dem Innenpol hochgezogen ist und der rotierbare Magnetsystemteil einen zur Quellenachse exzentrisch angeordneten Innenpol aufnimmt und einen zwischen Innenpol und stehendem Aussenpol liegenden zweiten Aussenpolteil aufnimmt derart, dass bei Rotation die Tunnelschlaufe des Magnetfeldes die Zerstäubungsfläche exzentrisch überstreicht, ergibt sich bei hoher Rate und Materialausnutzung eine gute und stabile Verteilung über die gesamte Targetlebensdauer, was zu einer wesentlichen Erhöhung der Wirtschaftlichkeit führt. Bevorzugte Anwendungen ergeben sich nach Anspruch 17. Bevorzugte weitere Ausführungsformen der erfindungsgemässen Magnetronzerstäubungsquelle sind in den Ansprüchen 2 bis' 16 definiert.

Die Figuren 1 bis 3 geben schematisch den Stand der Technik wider und die Figuren 4 bis 8 geben die erfindungsgemässe Anordnung beispielsweise und schematisch wider.

Es zeigen:
- Fig.1a: in Aufsicht eine rotierbare runde Magnetsystemanordnung mit Aussenpol und mit zur Zentrumsachse exzentrisch angeordnetem Innenpol gemäss Stand der Technik.
- Fig.1b: im Querschnitt und schematisch die Magnetsystemanordnung gemäss Fig.1a mit Target und Substratanordnung gemäss Stand der Technik.
- Fig.1c: in Aufsicht eine weitere rotierbare Magnetsystemanordnung mit zur Rotationsachse exzentrisch angeordnetem Magnetsystem gemäss Stand der Technik.
- Fig.1d: eine weitere Ausführung eines rotierbaren exzentrisch angeordneten Magnetsystems mit Kardioid ähnlicher Magnetanordnung.
- Fig.2: im Querschnitt und schematisch eine Magnetronanordnung mit gegenüber dem Innenpol hochgezogenen Aussenpol für stationär angeordnete Substratebenen gemäss Stand der Technik.
- Fig.3: im Querschnitt und schematisch eine weitere Anordnung mit gegenüber dem Innenpol hochgezogenen Aussenpol und konkav ausgebildetem Target gemäss Stand der Technik.
- Fig.4: eine erfindungsgemässe Magnetsystemanordnung schematisch und in Aufsicht mit stationärem Aussenpol und rotierbaren exzentrisch angeordneten Innenpol und Aussenpolteil, wobei der stationäre Aussenpol 3 gegenüber dem Innenpol am Targetrand hochgezogen ist.
- Fig.5: ein Querschnitt einer erfindungsgemässen Anordnung gemäss Fig.4.
- Fig.6: ein weiteres erfindungsgemässes Beispiel, detaillierter und schematisch im Schnitt dargestellt.
- Fig.7: ein Beispiel einer gemessenen Kurve für die durchschnittliche Verteilung an einem Substrat über die Targetlebensdauer.
- Fig.8: das Querschnittsprofil der einen Hälfte eines Targets als Beispiel für die erfindungsgemäss erzielbare Erosion über die Targetlebensdauer.

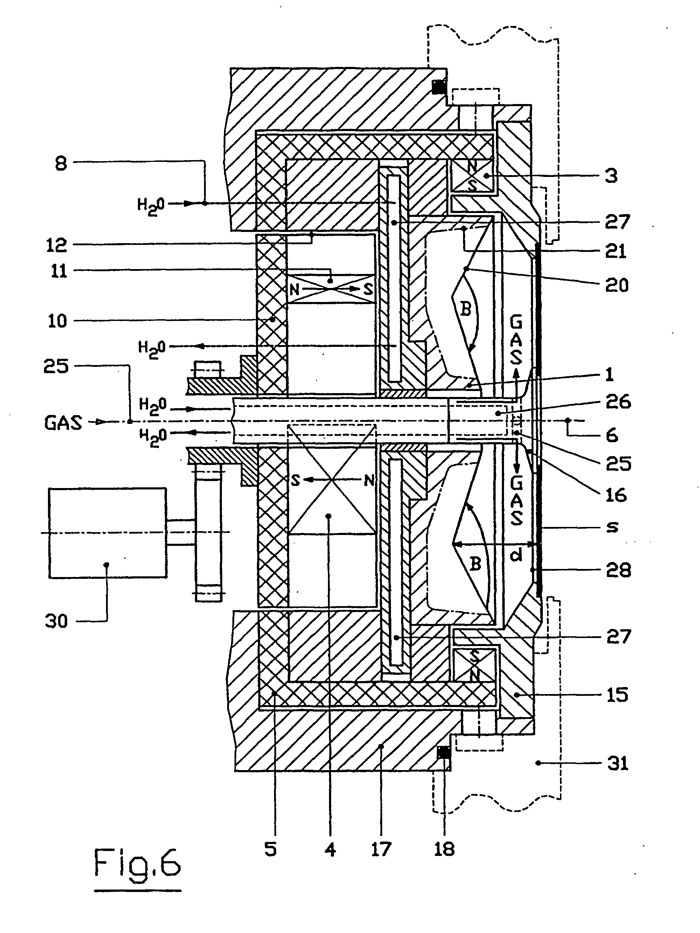

In Figur 5 ist eine erfindungsgemässe Magnetronzerstäubungsquelle im Querschnitt und schematisch dargestellt. Das Zerstäubungstarget 1 ist als ringförmiger Targetkörper ausgebildet, welcher im wesentlichen eine konkav ausgebildete Zerstäubungsfläche 20 aufweist. Die Zerstäubungsfläche 20 kann an sich auch plan ausgebildet sein, die konkave Ausbildung ist aber wesentlich vorteilhafter, da bei geringem Substratabstand d der Entladungsraum im wesentlichen aus der Zerstäubungsfläche 20 und der Substratfläche s besteht und somit die Verlustzone im Randbereich minimal ist. Das runde Target 1 ist für die Beschichtung von Speicherplatten s mit Vorteil kreisringförmig ausgebildet, wodurch es möglich ist im Zentrum eine Elektrode 16 hindurch zu führen entlang der Quellenzentrumsachse, welche gleichzeitig als Zentrumsmaske für das scheibenförmige Substrat s dient. Das Substrat s ist in geringem Abstand d vom Target 1 angeordnet und der Durchmesser des Targets 1 ist nur wenig grösser als der Durchmesser des Substrates s. Der dadurch gebildete Entladungsraum wird durch eine Elektrode 15, diesen Raum umschliessend, begrenzt. Durch diese Ausbildung sind die Restflächen 15 und 16, welche ebenfalls beschichtet werden im Verhältnis zur Nutzfläche des Substrates s minimiert und der sogenannte Materialübertragungsfaktor wird dadurch erhöht. Die Elektroden 15 und 16 werden üblicherweise bei Gleichstrombetrieb anodisch geschaltet und das Target 1 katodisch. Es können aber auch in bekannter Weise solche Elektroden floatend oder auf einem Bias betrieben werden. Das Magnetsystem besteht aus einem im Randbereich des Target 1 hochgezogenen umschliessenden Aussenpol 3 und einem zur Quellenachse 6 hinter dem Target 1, exzentrisch angeordneten Innenpol 4, wobei zwischen dem Innenpol 4 und dem Aussenpol 3 ein zweiter Aussenpolteil 11 angeordnet ist, der eine Teilfunktion des Aussenpols 3 übernimmt. Der zweite Aussenpolteil 11 ist beispielsweise als segmentartiges Teil ausgebildet welches eine Art Ausschnitt aus dem ringförmigen Aussenpol 3 darstellt, aber versetzt und drehbar angeordnet ist. Die zum Target 1 hin gerichteten Pole sind derart definiert, dass der Innenpol 4 ein Gegenpol zum Aussenpol 3 und zum Aussenpolteil 11 darstellt, so dass die bereits erwähnten tunnelförmigen Magnetfelder B über der Zerstäubungsfläche 20 entstehen, welche eine ringförmige geschlossene Schlaufe für den Plasmaeinschluss bilden. Die Pole 3, 4 und 11 werden mit Vorteil direkt aus Permanentmagnetmaterial ausgebildet wobei bevorzugterweise Permanentmagnetmaterial der selten Erd Typen verwendet wird, wie Kobalt- Samarium und insbesondere vom Typ Neodym. Für den magnetischen Rückschluss werden im Rückseitenbereich der Permanentmagnete in bekannter Art Eisenjoche 5,10 verwendet. Der Aussenpol 3 ist erfindungsgemäss stationär, entlang der Targetperipherie, diese umschliessend, angeordnet und parallel zur Zentrumsachse 6 gegenüber dem Innenpol 4 und dem zweiten Aussenpolteil 11 am Targetrand hochgezogen. Durch das Mass des Hochziehens des Aussenpols 3 gegenüber dem Innenpol 4 kann in gewissen Grenzen das Erosionsprofil 21 das durch den Zerstäubungsvorgang am Target 1 entsteht beeinflusst und optimiert werden. Der Aussenpol 3 sollte aber vorteilhafterweise nicht über den Targetrand hinaus in Achsrichtung 6 verschoben werden. Der exzentrisch angeordnete Innenpol 4 und das ebenfalls exzentrisch angeordnete Aussenpolteil 11 ist auf einem zweiten Rückschlussjoch 10 rotierbar um die Achse 6 montiert und gelagert derart, dass zwischen dem ersten Rückschlussjoch 5, welches das zweite Rückschlussjoch 10 umschliesst, ein geringer Luftspalt ausgebildet wird, so dass die Innenpolmagnete 4 und die Magnete 11 des Aussenpolteils 11 mit dem zweiten Joch 10 frei um die Achse 6 drehen können. Das zweite Joch 10 ist mit Vorteil als runde Platte ausgebildet, welche die Magnete 4,11 in einem Magnetgehäuse 12 aufnehmen können. Durch die Rotation des Magnetsystemteil 4,10,11 wird trotz stationärem Magnetsystemteil 3,5 erreicht, dass die tunnelförmige Magnetfeldschleife B und somit die erzeugte Plasmaringentladung gegenüber der Achse 6 exzentrisch bewegt werden kann und dadurch die Zerstäubungsfläche 20 durch das Plasma auf gewünschte Art und Weise überstrichen wird. Hierdurch kann das entstehende Erosionsprofil 21 vorbestimmt und auf gewünschte Art beeinflusst werden.

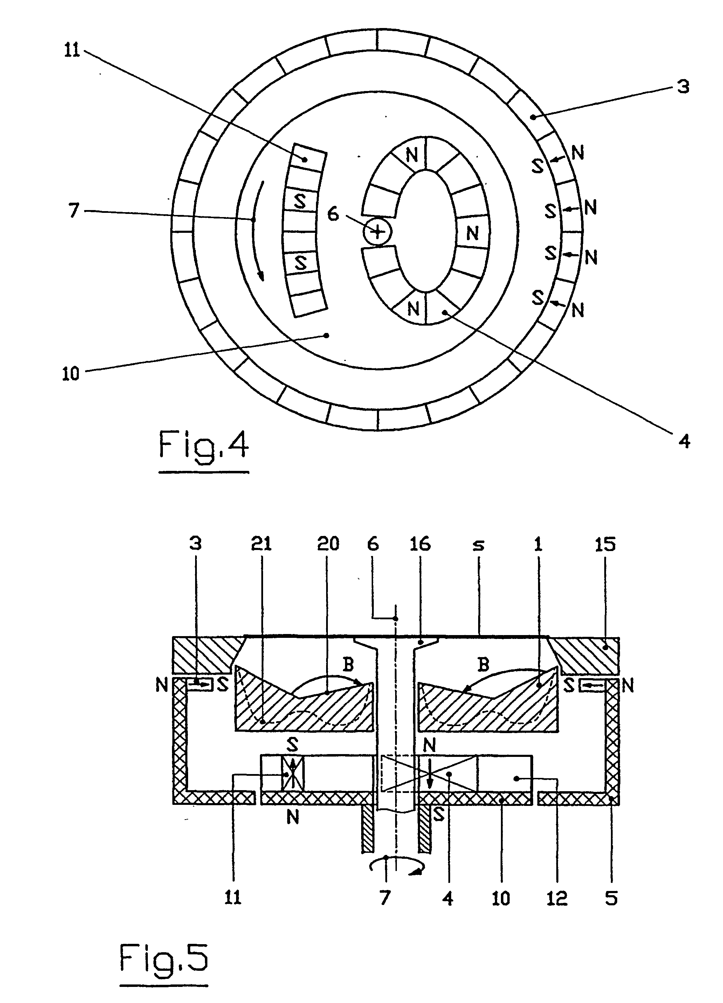

Die erfindungsgemässe Quelle entsprechend der Figur 5 ist zur Verdeutlichung der beispielsweisen Magnetanordnung in Figur 4 in Aufsicht dargestellt. Auf dem Rückschlussjoch 10, welches in der Regel aus Eisen ist sind exzentrisch Magnete 4 welche den Innenpol darstellen montiert, wobei der Innenpol 4 exzentrisch so angeordnet ist, dass dieser mit Vorteil, bis knapp in die Nähe der Zentrumsachse 6 reicht. Der zweite Aussenpolteil 11, welcher segmentförmig ausgebildet ist, besteht ebenfalls aus Permanentmagneten und ist auf dem runden plattenförmigen Joch gegenüber dem Innenpol 4 beabstandet angeordnet, so dass die magnetischen Feldlinien sich über den Polen 11 und 4 schliessen und im Bereich wo kein zweiter Aussenpolteil 11 gegenüber dem Innenpol 4 benachbart ist sich die Feldlinien über dem Innenpol 4 und dem Aussenpol 3 schliessen. Der Magnetsystemteil montiert auf der rotierbaren Jochplatte 10 rotiert in Rotationsrichtung 7 um die zentrale Quellenachse, wobei der Aussenpol 3 stationär bleibt. Die dadurch ausgebildete exzentrisch angeordnete Magnetronelektronenfalle rotiert somit um die Achse 6 und damit auch die Plasmaschleife.

Der Targetsubstratabstand zur tiefsten Stelle des konkaven Target 1 wird mit Vorteil kleiner als 60 mm gewählt wobei Werte von weniger als 40 mm sehr gute Verhältnisse in bezug auf Materialausnutzung und Verteilung ergeben und Werte von weniger als 35 mm noch bessere Übertragungsfaktoren bedeuten bei typischen Substratscheibendurchmessern von 120 mm. Um eine stabile Plasmaentladung gewährleisten zu können sind Abstände unter 20 mm nicht mehr empfehlenswert. Der Targetdurchmesser sollte hierbei bis zu 30% grösser sein als der Substratdurchmesser vorzugsweise aber nicht grösser als um 25%. Die Quelle ist vorteilhafterweise für scheibenförmige Substrate geeignet, insbesondere mit einem Durchmesser von 50 bis 150 mm, wobei für die im Bereich von 70 bis 150 mm die Anordnung besonders geeignet ist und wo die typischen Abmessungen für Speicherplatten liegen.

Ein praktisches und bevorzugtes Ausführungsbeispiel der erfindungsgemässen Quelle ist detaillierter und schematisch im Querschnitt in Figur 6 dargestellt. Das Zerstäubungstarget 1 ist bevorzugt als ringförmiger Körper ausgebildet mit einer Öffnung im Zentrum. Mit Vorteil ist der ringförmige Körper im Bereich der Zerstäubungsfläche 20 konkav, rinnenförmig ausgebildet und besonders vorteilhaft im wesentlichen V-förmig. Der Aussenrand des Targets 1 liegt etwas höher als der Innenrand. Der tiefste Punkt der Rinnen, beziehungsweise V-fömigen Zerstäubungsfläche 20 liegt gegenüber der Zerstäubungsachse 6, in etwa, beim halben Targetradius Rt. Das Target wird rückseitig auf übliche Weise mit Kühlmitteln gekühlt, beispielsweise einer Kühlwasser durchflossenen Kühlplatte 27. An der zerstäubungsflächenseitigen Peripherie des Targets 1 ist eine ringförmige Blende 15, welche als Gegenelektrode zum Target 1 geschaltet ist, angeordnet. Im vorliegenden Beispiel ist die Anode 15 elektrisch auf Anlagenpotential beziehungsweise auf Massenpotential geschaltet. Die Anode 15 weist eine Aufnahmeöffnung 28 auf, in welche das scheibenförmige Substrat s platziert wird. Die Anordnung ist derart ausgebildet, dass gegenüber dem tiefsten Punkt der Zerstäubungsfläche 20 und dem Substrat ein Abstand d von 20 bis 60 mm erzeugt wird vorzugsweise im Bereich von 20 bis 40 mm. Diese Anordnung bildet zusammen den Plasmaraum aus, wobei darauf geachtet wird, dass die für die Beschichtung nicht nutzbare Fläche der Elektrode 15 gering bleibt. Die Öffnung 28 hat hierbei zum Beispiel einen Durchmesser von etwa 120 mm um entsprechende Substrate s aufnehmen zu können. Um noch bessere Verteilungswerte zu erzielen, können Substrate s im Bereich der Öffnung 28 auch noch um ihre Achse 6 rotiert werden oder sogar gegenüber der Achse 6 leicht exzentrisch versetzt rotierbar angeordnet werden. Möglich ist auch das Positionieren von mehr als einem Substrat in der Ebene 28. Im weiteren kann durch neigen der Substratebene gegenüber der vertikalen Ebene durch die Quellenachse 6 ein weiterer Einstellparameter eingeführt werden wenn besonders schwierige Verteilungsanforderungen dies erforderlich machen. Für optische Speicherplatten, welche im Zentrum eine Öffnung aufweisen, wird eine zentrale Maske 16 benötigt, welche gleichzeitig als Halterung und als zusätzliche Anode wirkt. Die Zentrumsmaske 16 ist durch eine Öffnung des Targets 1 im Zentrum hindurchgeführt und wird über eine Kühlmittelzuführung 26 mit Vorteil gekühlt. Ausserdem kann über diese Zentrumsmaske 16 das Entladungsgas 25 zugeführt werden. Die Zentrumsmaske ist in ihrer Verlängerung durch die Kühlplatte 27 und den rotierbaren Magnetsystemteil 4,10,11,12, entlang der Achse 6, hindurchgeführt. Die Zentrumsmaske 16 kann auch elektrisch floatend betrieben werden, wobei dann nur die Elektrode 15, welche das Substrat S umgibt, anodisch geschaltet ist.

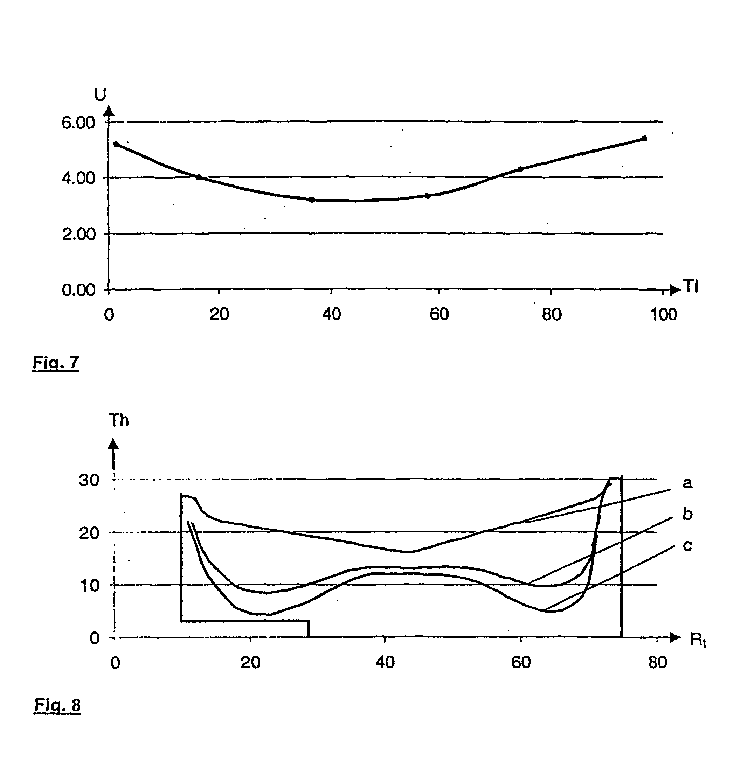

Der exzentrisch zur Drehachse 6 angeordnete Innenpol 4 und der zweite Aussenpolteil bestehen aus selten Erdmagneten und sind auf dem zweiten Eisenjoch 10, welches als runde Trägerplatte ausgebildet ist, montiert, wobei das ganze Magnetsystemteil mit einem Gehäusedeckel 12 abgeschlossen ist. Dieser rotierbare Magnetsystemteil wird über eine Antriebsvorrichtung 30, beispielsweise einen Elektromotor mit Getriebe angetrieben. Das äussere und stationär angeordnete Joch 5, welches magnetisch gekoppelt ist mit dem rotierbaren Joch 10 wird entlang der Peripherie des Targets 1 hochgezogen und trägt im Endbereich Aussenpolmagnete 3, welche die Pole bilden derart, dass über der Zerstäubungsfläche 20 ein tunnelförmiges Magnetfeld B mit einer geschlossenen Schleife entsteht. Durch die Rotation des Magnetsystemteils 4,10,11 wird die Magnetfeldschleife über der Zerstäubungsfläche 20 exzentrisch um die zentrale Achse 6 bewegt, wodurch die gewünschte Erosionscharakteristik erzeugt wird. Der Aussenpol 3 reicht mit Vorteil nicht über die Peripherie des Targets 1 in Richtung Substratebene s hinaus. Zusätzliche Massnahmen zum Schutz der Magnete 3 und zur Verhinderung von parasitären Entladungen in unerwünschten Bereichen, in Polnähe, sind dadurch möglich, dass laby-, rinthartige und dunkelraumschirmartige Abdeckungen zwischen Targetperipherie und Aussenpol 3 vorgesehen werden. Dies kann wie im dargestellten Beispiel gezeigt kombiniert werden mit entsprechender Ausbildung der äusseren Anode 15. Die ganze Quelle kann auf übliche Art und Weise in ein vakuumdichtes Gehäuse 17 eingebaut werden, welches über eine Vakuumdichtung 18 an eine Vakuumanlage 31 angeflanscht wird. Eine beispielsweise dargestellte, realisierte Magnetronsputterquelle weist folgende Dimensionen auf:
- Targetdurchmesser: 150 mm
- Targetdicke: 30 mm
- Targetform: im wesentlichen V-förmig gemäss Figur 8 wobei Th die Targetdicke bezeichnet und Rt den Tartetradius in mm und a die Zerstäubungsneufläche 20 definiert
- Targetmaterial: Silber, beziehungsweise Silberlegierung
- Targetausnutzung: > 45%
- Transferfaktor des Targetmaterials: > 45%
- Schichtdickenverteilung: ca. 5 %
- Target-Substratabstand: d=30 mm
- Zerstäubungsgas und Druck: Ar, ca. 10⁻³ Millibar
- Anzahl CDR-Beschichtungen; > 110'000 / Target
- Substratdurchmesser: 120 mm (CDR)
- Schichtdicke am Substrat: ca. 700 Å
Es zeigt sich, dass mit der vorliegenden Erfindung vor allem über die ganze Targetstandzeit bei mehr als 110'000 beschichteten Speicherplatten eine Schichtdickengenauigkeit über den Nutzbereich der Speicherplatte von ca. 5 % eingehalten werden konnte. Dieses Ergebnis ist in der Figur 7 dargestellt. Die Verteilung U in Prozent über die Targetlebensdauer, bezogen auf Anzahl T1 beschichteter Substrate s in tausender Einheit angegeben weist einen sehr gleichförmigen und konstanten Verlauf aus, im Bereich von etwa 3,5 bis 5 % Verteilungsgenauigkeit. Ein weiterer Vorteil der Anordnung besteht darin, dass das Targetmaterial besser genutzt wird, womit einerseits eine grössere Anzahl Beschichtungen T1 möglich ist bevor das Target 1 gewechselt werden muss und andererseits Material gespart werden kann, was insgesamt zu einer höheren Wirtschaftlichkeit führt. Ein sehr wichtiger Punkt hierbei ist ausserdem, dass über die Lebensdauer T1 des Targets 1 nicht nur die Verteilungsverhältnisse U sehr konstant bleiben, sondern auch die Entladungsbedingungen. Dies wird vor allem durch die gleichförmige und gezielte Erosionscharakteristik der Quelle über die Targetlebensdauer erreicht, wie dies in Figur 8 anhand eines Beispiels dargestellt ist.

In Figur 8 ist ein Querschnitt durch eine Hälfte eines ringförmigen Targets mit V-förmiger Zerstäubungsneufläche 20 mit der Profilkurve a dargestellt und mit zwei Erosionsprofilkurven. b und c nach verschiedenen Betriebszeiten. Profil b zeigt eine Ausbildung nach etwa 2/3 der Targetlebensdauer und das Profil c in etwa am Ende der Targetlebensdauer. Es ist sofort ersichtlich, dass die Profile sehr gleichmässig sind und in der Form kaum von einander abweichen und im wesentlichen symmetrisch verlaufen. Dies hat zur Folge, dass auch die Plasmabedingungen konstant und reproduzierbar bleiben, auch über relativ starke Erosionswege Th des Targets 1.

Für Speicherplattenanwendungen der erwähnten Art mit Durchmessern im Bereich von 50 bis 150 mm eignet sich ein ringförmiges Target welches konkav ausgebildet ist, das heisst ringförmig um die Achse 6 angeordnet ist vorzugsweise mit einer Art V-förmigem Profil. Hierbei ist die Neigung der Innenfläche gegenüber einer planen Fläche mit Vorteil im Bereich von 5 bis 30 Grad, vorzugsweise im Bereich von 10 bis 20 Grad zu wählen, wobei die Neigung der Aussenfläche im Bereich von 12 bis 30 Grad, vorzugsweise im Bereich von 15 bis 25 Grad zu wählen ist, um gute Ergebnisse zu erreichen. Der tiefste Punkt des konkaven Targets liegt hierbei etwa im mittleren Radiusbereich des Targets 1 vorzugsweise im Bereich des 0,4 bis 0,7 fachen des Targetradius.

Die erfindungsgemässe Zerstäubungsquelle ist an sich geeignet um alle bekannten Materialien zu zerstäuben. Bevorzugt ist die Quelle einsetzbar zur Zerstäubung von Metallen oder Metallegierungen. Reaktiv Prozesse bei denen neben Argon auch ein zusätzliches Reaktivgas wie beispielsweise Sauerstoff oder Stickstoff verwendet wird sind ebenfalls möglich. Neben einem reinen DC-Zerstäubungsverfahren sind auch Hochfrequenz, Mittelfrequenz oder DC und AC überlagerte Prozesse möglich insbesondere aber auch der Betrieb mit gepulster beziehungsweise modulierter Speisung. Die Quelle ist insbesondere geeignet für die Zerstäubung von Metallen und/oder deren Legierungen im DC-, beziehungsweise DC-puls-Betrieb. Wegen der hohen Targetausnutzung und des guten Materialausnutzungsgrades sind hohe Standzeiten des Targets erreichbar, womit die Quelle gut für Anlagen einsetzbar ist bei welchen hohe Taktraten erzielt werden sollen und somit hohe Durchsätze bei grosser Wirtschaftlichkeit.

Aluminium und Aluminiumlegierungen werden besonders oft eingesetzt bevorzugterweise für optische Speicher wie beispielsweise CD's und DVD's (L1-Layer DVD9). Die vorerwähnten Vorteile führen auch dazu, dass Edelmetalle besonders wirtschaftlich abgeschieden werden können. Hierbei spielt Silber und dessen Legierungen eine besondere Rolle, weil Silber bei üblichen Quellen eher schlechte Ausnutzungsgrade ergibt. Insbesondere bei optischen Speicherplattenanwendungen wie CD-R und DVD spielen Silber und Silberlegierungen eine grosse Rolle und die erfindungsgemässe Quelle hierzu eine besonders wirtschaftliche Lösung. Die erfindungsgemässe Quelle eignet sich besonders für scheibenförmige Speicherplatten, wie auch magnetische Speicherplatten insbesondere aber für optische Speicher wie beispielsweise für CD's, CDR's, CD-RW's und weit bevorzugt für DVD's.

Die erfindungsgemässe Zerstäubungsquelle ermöglicht es eine sehr gute Schichtdickenverteilung bei gleichzeitig hoher Übertragungsrate, Targetnutzungsgrad, langer Targetstandzeit und hoher spezifischer Abscheiderate zu kombinieren. Dadurch dass das Target an denjenigen Stellen eine grosse Dicke aufweist an denen sich die wesentlichen Zerstäubungszonen befinden wird auch eine hohe Targetausnutzung von über 40%, ja sogar über 45% möglich, wobei durch die spezielle Formgebung der Anordnung gegenüber dem Substrat ein Übertragungsfaktor von besser 45%, sogar besser 50% möglich ist. Bei runden Targetanordnungen ist vor allem in Aussenbereich des Targets ein grosser Materialanteil vorhanden, der auch durch in den Aussenbereich angelegte Zerstäubungszone eine hohe Materialausnutzung garantiert. Die Kombination einer konkaven Targetausbildung bei geringem Targetsubstratabstand und geringen Targetdurchmessern mit der Möglichkeit grosse Targetdicken gleichmässig erodieren zu können und trotzdem über die ganze Lebensdauer eine gute und stabile Verteilung erzielen zu können, ermöglicht die Herstellung insbesondere von Speicherplatten auf besonders wirtschaftliche Art. Ein weiterer Vorteil der erfindungsgemässen Quellenanordnung besteht darin, dass nur ein Teil des Magnetsystems zu drehen ist, was zu einer einfacheren Bauweise führt und durch den geringen Aussenumfang des drehenden Magnetsystemteils ein wesentlicher Vorteil für die einfache Konstruktion der Katode bedeutet.

## Patentansprüche

1. Magnetronzerstäubungsquelle mit einem runden Targetkörper (1) dessen Stirnseite eine Zerstäubungsfläche (20, 21) aufweist, mit einem Magnetsystem (2,3,4,5,10,11) enthaltend einen Innenpol (4) und einen diesen ringförmig umgebenden Aussenpol (3), derart dass sich ein Magnetfeld (B) über der Zerstäubungsfläche (20,21) in Form einer geschlossenen tunnelartigen Schleife um die zentrale Quellenachse (6) ausbildet, und dass mindestens ein Teil des Magnetsystems (2,3,4,5,10,11) um die Quellenachse (6) rotierbar gelagert ist und diesen mit Antriebsmittel (30) wirkverbunden ist **dadurch gekennzeichnet, dass** der ringförmige Aussenpol (3) nicht in gleicher Ebenen mit dem Innenpol (4) liegt und im Randbereich des runden Targetkörpers (1) hochgezogen ist und der rotierbare Magnetsystemteil den zur Achse (6) exzentrisch angeordneten Innenpol (4) aufnimmt und einen zwischen Aussenpol (3) und Innenpol (4) liegenden zweiten Aussenpolteil (11) aufnimmt, derart dass bei Rotation die Tunnelschleife des Magnetfeldes (B) die Zerstäubungsfläche (20,21) exzentrisch überstreicht.

2. Quelle nach Anspruch 1 **dadurch gekennzeichnet, dass** das Magnetsystem (2,3,4,5,10,11) Permanentmagnete enthält, insbesondere vom Typ selten-Erdmagnete wie Kobalt-Samarium enthaltend und/oder Neodym.

3. Quelle nach Anspruch 2 **dadurch gekennzeichnet, dass** das Magnetsystem (2,3,4,5,10,11) ein magnetisches Joch (5,10) aus hochpermeablem Material beinhaltet für den Rückschluss des magnetischen Kreises innerhalb der Quellenanordnung.

4. Quelle nach Anspruch 3 **dadurch gekennzeichnet, dass** das Joch (5,10) zweiteilig konzentrisch ausgebildet ist und einen ersten äusseren stationären Teil (5) und einen zweiten inneren rotierbar gelagerten Teil (10) aufweist.

5. Quelle nach Anspruch 4 **dadurch gekennzeichnet, dass** das innere Jochteil (10) den Innenpol (4) und Aussenpolteil (11) aufnimmt.

6. Quelle nach einem der Ansprüche 1 bis 5 **dadurch gekennzeichnet, dass** mindestens einer der Pole (3,4,11) aus permanentmagnetischem Material bestehen, vorzugsweise alle drei Pole (3,4,11).

7. Quelle nach einem der vorhergehenden Ansprüche 1 bis 6 **dadurch gekennzeichnet, dass** der magnetische Kreis des Magnetsystems so ausgebildet ist, dass die Richtcharakteristik bezüglich der abgestäubten Teilchen der Zerstäubungsfläche (20,21) auf ein davor angeordnetes flaches Substrat (s) während des Zerstäubungsbetriebes über die Lebensdauer des Targetkörpers (1) im.wesentlichen gleich erhalten bleibt.

8. Quelle nach einem der vorhergehenden Ansprüche 1 bis 7 **dadurch gekennzeichnet, dass** die Zerstäubungsfläche (20) mindestens in Teilbereichen konkav ausgebildet ist.

9. Quelle nach einem der vorhergehenden Ansprüche 1 bis 8 **dadurch gekennzeichnet, dass** im Quellenzentrum entlang der Quellenachse (6) eine Zentrumsmaske (16) vorgesehen ist, die den Targetkörper in Richtung zur Substrateben (s) durchdringt und diese elektrisch nicht mit dem Target zusammengeschaltet ist und vorzugsweise eine Gegenelektrode zum Target (1) insbesondere Anode bildet, oder floatend angeordnet ist.

10. Quelle nach einem der vorhergehenden Ansprüche 1 bis 9 **dadurch gekennzeichnet, dass** der Targetkörper (1) die Zentralachse (6), insbesondere die Zentralmaske (16), ringförmig umschliesst und die Zerstäubungsfläche (20) vorzugsweise konkav beziehungsweise rinnenförmig ausgebildet ist, und vorzugsweise im Querschnitt im wesentlichen eine V-förmige Zerstäubungsneufläche (20) aufweist.

11. Quelle nach einem der vorhergehenden Ansprüche 1 bis 10 **dadurch gekennzeichnet, dass** der Aussenpol-Magnet (3) im Bereich der Peripherie des Targetkörpers (1) und der Zerstäubungsfläche (20) angeordnet ist.

12. Quelle nach einem der vorhergehenden Ansprüche 1 bis 11 **dadurch gekennzeichnet, dass** eine Gegenelektrode (15) den Targetkörper (1) im Bereich der Zerstäubungsflächenperipherie (20) umschliesst wobei diese eine Aufnahmeöffnung (28) bildet zur Aufnahme eines Substrates (s).

13. Quelle nach Anspruch 12 **dadurch gekennzeichnet, dass** der grösste Abstand (d) zwischen der Targetneufläche (20) und der Ebenen der Aufnahmeöffnung (28) im Bereich von 20 bis 60 mm liegt, vorzugsweise zwischen 20 bis 40 mm.

14. Quelle nach Anspruch 13 **dadurch gekennzeichnet, dass** die Aufnahmeöffnung (28) Substrate (s) mit einem Durchmesser von 50 bis 150 mm vorzugsweise von 70 bis 150 mm aufnehmen kann.

15. Quelle nach einem der Ansprüche 13 bis 14 **dadurch gekennzeichnet, dass** der Durchmesser der Zerstäubungsfläche (20) grösser ist als der Durchmesser der Aufnahmeöffnung (28), vorzugsweise um bis zu 30%, insbesondere um bis zu 25%.

16. Quelle nach einem der Ansprüche 1 bis 15 **dadurch gekennzeichnet, dass** der Targetkörper (1) aus Metall oder einer Metallegierung besteht, vorzugsweise eines der Metalle Silber, Gold oder Aluminium enthält.

17. Verwendung der Zerstäubungsquelle nach einem der Ansprüche 1 bis 16 für das Zerstäubungsbeschichten von Speicherplatten, insbesondere für optische Speicher wie CD's, CDR's, CD-RW's und bevorzugt für DVD's.

## Claims

1. Magnetron sputter source comprising a round target body (1), the front face of which has a sputter face (20, 21), with a magnet system (2, 3, 4, 5, 10, 11) comprising an inner pole (4) and surrounding this an annular outer pole (3), such that a magnetic field (B) develops over the sputter face (20, 21) in the form of a closed tunnel-like loop about a central source axis (6) and that at least a portion of the magnet system (2, 3, 4, 5, 10, 11) is supported rotatable about the source axis (6) and actively connected to driving means (30), **characterised in that** the annular outer pole (3) does not lie in the same plane as the inner pole (4) and is raised in the edge area of the round target body (1) and the rotatable magnet system portion holds the inner pole (4) arranged eccentrically to the axis (6) and a second outer pole part (11) lying between the outer pole (3) and the inner pole (4) such that on rotation the tunnel loop of the magnetic field (B) sweeps eccentrically over the sputter face (20, 21).

2. Source according to claim 1, **characterised in that** the magnet system (2, 3, 4, 5, 10, 11) comprises permanent magnets, in particular of the rare earth magnet type such as containing cobalt-samarium and/or neodymium.

3. Source according to claim 2, **characterised in that** the magnet system (2, 3, 4, 5, 10, 11) comprises a magnetic yoke (5, 10) of highly permeable material for the return connection of the magnetic circuit within the source arrangement.

4. Source according to claim 3, **characterised in that** the yoke (5, 10) is formed concentrically in two parts and has a first outer stationary part (5) and a second inner rotatably mounted part (10).

5. Source according to claim 4, **characterised in that** the inner yoke part (10) holds the inner pole (4) and the outer pole part (11).

6. Source according to any of claims 1 to 5, **characterised in that** at least one of the poles (3, 4, 11) comprises permanent magnet material, preferably all three poles (3, 4, 11).

7. Source according to any of the previous claims 1 to 6, **characterised in that** the magnetic circuit of the magnet system is formed such that the directional characteristic in relation to the sputtered particles of the sputter face (20, 2 1 ) onto a flat substrate (s) arranged in front thereof during sputtering operation remains essentially constant over the life of the target body (1).

8. Source according to any of the previous claims 1 to 7, **characterised in that** the sputter face (20) is formed concave at least in part areas.

9. Source according to any of the previous claims 1 to 8, **characterised in that** in the source centre along the source axis (6) is provided a centre mask (16), which penetrates the target body in the direction towards the substrate plane (s) and is not electrically connected to the target and preferably forms a counter electrode to the target (1), in particular an anode, or is arranged floating.

10. Source according to any of the previous claims 1 to 9, **characterised in that** the target body (1) surrounds annularly the central axis (6), in particular the centre mask (16), and the sputter face (20) is formed concave or channel-shaped, and preferably has a new sputter face (20) which is essentially V-shaped in cross-section.

11. Source according to any of the previous claims 1 to 10, **characterised in that** the outer pole magnet (3) is arranged in the region of the periphery of the target body (1) and the sputter face (20).

12. Source according to any of the previous claims 1 to 11, **characterised in that** a counter electrode (15) surrounds the target body (1) in the region of the sputter face periphery (20), forming a receiving opening (28) to hold a substrate (s).

13. Source according to claim 12, **characterised in that**, the greatest distance (d) between the new target face (20) and the planes of the receiving opening (28) lies in the range from 20 to 60 mm, preferably between 20 and 40 mm.

14. Source according to claim 13, **characterised in that** the receiving opening (28) can hold a substrate (s) with a diameter of 50 to 150 mm, preferably from 70 to 150 mm.

15. Source according to one of claims 13 or 14, **characterised in that** the diameter of the sputter face (20) is greater than the diameter of the receiving opening (28), preferably by up to 30%, in particular by up to 25%.

16. Source according to any of claims 1 to 16, **characterised in that** the target body (1) comprises metal or a metal alloy, preferably one of the metals silver, gold or aluminium.

17. Use of the sputter source according to any of claims 1 to 16 for the sputter coating of storage discs, in particular optical storage discs such as CDs, CDRs, CD-RWs and preferably DVDs.

## Revendications

1. Source de pulvérisation de magnétron comportant un corps de cible rond (1) dont le côté frontal présente une surface de pulvérisation (20, 21), et un système magnétique (2, 3, 4, 5, 10, 11) qui contient un pôle intérieur (4) et un pôle extérieur (3) entourant celui-ci suivant une forme annulaire de telle sorte qu'un champ magnétique (B) se forme sur la surface de pulvérisation (20, 21), sous la forme d'une boucle fermée en forme de tunnel autour de l'axe de source central (6) et qu'une partie au moins du système magnétique (2, 3, 4, 5, 10, 11) est montée pour pouvoir tourner autour de l'axe de source (6) et est en relation fonctionnelle avec un moyen d'entraînement (30), **caractérisée en ce que** le pôle extérieur annulaire (3) n'est pas situé dans le même plan que le pôle intérieur (4) et est surélevé dans la zone du bord du corps de cible rond (1), et la partie de système magnétique rotative reçoit le pôle intérieur (4) excentré par rapport à l'axe (6) et reçoit une seconde partie de pôle extérieur (11) située entre le pôle extérieur (3) et le pôle intérieur (4), de telle sorte que lors de la rotation, la boucle en forme de tunnel du champ magnétique (B) balaie de manière excentrée la surface de pulvérisation (20, 21).

2. Source selon la revendication 1, **caractérisée en ce que** le système magnétique (2, 3, 4, 5, 10, 11) contient des aimants permanents, en particulier du type à terres rares contenant par exemple du cobalt-samarium et/ou du néodyme.

3. Source selon la revendication 2, **caractérisée en ce que** le système magnétique (2, 3, 4, 5, 10, 11) contient une culasse magnétique (5, 10) en matière très perméable pour le court-circuit du circuit magnétique à l'intérieur du dispositif de source.

4. Source selon la revendication 3, **caractérisée en ce que** la culasse (5, 10) a une forme concentrique en deux parties et comporte une première partie fixe extérieure (5) et une seconde partie rotative intérieure (10).

5. Source selon la revendication 4, **caractérisée en ce que** la partie de culasse intérieure (10) reçoit le pôle intérieur (4) et la partie de pôle extérieure (11).

6. Source selon l'une des revendications 1 à 5, **caractérisée en ce que** l'un au moins des pôles (3, 4, 11) se compose d'une matière magnétique permanente, de préférence les trois pôles (3, 4, 11).

7. Source selon l'une des revendications 1 à 6 précédentes, **caractérisée en ce que** le circuit magnétique du système magnétique est conçu pour que la caractéristique directionnelle par rapport aux particules pulvérisées de la surface de pulvérisation (20, 21) sur un substrat plat (s) disposé devant elle reste sensiblement égale, pendant la pulvérisation, sur la durée de vie du corps de cible (1).

8. Source selon l'une des revendications 1 à 7 précédentes, **caractérisée en ce que** la surface de pulvérisation (20) est concave au moins dans des zones partielles.

9. Source selon l'une des revendications 1 à 8 précédentes, **caractérisée en ce qu'**il est prévu au centre de la source, le long de l'axe de source (6), un masque central (16) qui traverse le corps de cible en direction du plan de substrat (s), et ce masque central (6) n'est pas relié électriquement à la cible et forme de préférence une contre-électrode pour la cible (1), en particulier une anode, ou est disposé de manière flottante.

10. Source selon l'une des revendications 1 à 9 précédentes, **caractérisée en ce que** le corps de cible (1) entoure l'axe central (6), en particulier le masque central (16), suivant une forme annulaire et la surface de pulvérisation (20) a de préférence une forme concave ou la forme d'un conduit et présente de préférence, en coupe transversale, une surface de pulvérisation neuve (20) sensiblement en V.

11. Source selon l'une des revendications 1 à 10 précédentes, **caractérisée en ce que** l'aimant à pôle extérieur (3) est disposé dans la zone de la périphérie du corps de cible (1) et de la surface de pulvérisation (20).

12. Source selon l'une des revendications 1 à 11 précédentes, **caractérisée en ce qu'**une contre-électrode (15) entoure le corps de cible (1) dans la zone de la périphérie de surface de pulvérisation (20), cette contre-électrode formant une ouverture de réception (28) pour recevoir un substrat (s).

13. Source selon la revendication 12, **caractérisée en ce que** la distance maximale (d) entre la surface de cible neuve (20) et le plan de l'ouverture de réception (28) est de l'ordre de 20 à 60 mm, de préférence de 20 à 40 mm.

14. Source selon la revendication 13, **caractérisée en ce que** l'ouverture de réception (28) peut recevoir des substrats (s) d'un diamètre de 50 à 150 mm, de préférence de 70 à 150 mm.

15. Source selon l'une des revendications 13 à 14, **caractérisée en ce que** le diamètre de la surface de pulvérisation (20) est supérieur au diamètre de l'ouverture de réception (28), de préférence jusqu'à 30 % et plus spécialement jusqu'à 25 %.

16. Source selon l'une des revendications 1 à 15, **caractérisée en ce que** le corps de cible (1) est en métal ou en alliage métallique, et contient de préférence l'un des métaux constitués par l'argent, l'or ou l'aluminium.

17. Utilisation de la source de pulvérisation selon l'une des revendications 1 à 16 pour revêtir par pulvérisation des disques de mémoire, en particulier des mémoires optiques telles que des CD, des CD enregistrables, des CD réinscriptibles et de préférence des DVD.
